# EUROPEAN PATENT APPLICATION

(11) **EP 4 066 976 A1**
(43) Date of publication of application: **05.10.2022**
(21) Application number: 19953826.5
(22) Date of filing: 26.11.2019
(51) Int. Cl.: B23K 1/00, H05K 3/34

(54) **COMPONENT MOUNTING METHOD, AND COMPONENT MOUNTING SYSTEM**

(71) Applicant: Fuji Corporation, Chiryu-shi, Aichi 472-8686 (JP)
(72) Inventor: SAKURAYAMA, Takeshi, Chiryu-shi, Aichi 472-8686 (JP)
(74) Representative: Grünecker Patent- und Rechtsanwälte PartG mbB
(86) International application number: PCT/JP2019/046056
(87) International publication number: WO 2021/106056

(57) **Abstract**

A component mounting method includes an application step of applying a specific solder paste including Sn and a metal other than Sn to a board; a disposition step of positioning and disposing an upper surface reference type component having a positioning reference on an upper surface with respect to one or more reference points on the board; and a reflow step of reflow-soldering the component by heating the board, in which in the specific solder paste, at least a part of the Sn is melted, and molten Sn and the metal other than Sn form an intermetallic compound in the reflow step, thereby fixing the upper surface reference type component to the board.

## Description

### Technical Field

The present specification discloses a component mounting method and a component mounting system.

### Background Art

In the conventional art, as a component mounting method of this type, a component is bonded by using not only a solder paste but also an adhesive when an upper surface reference type component such as an LED having a reference for a mounting position on an upper surface is mounted. For example, in a component mounting method of Patent Literature 1, by suppressing a self-alignment effect of a solder paste during reflow-soldering by curing an adhesive, it is prevented that an upper surface of an upper surface reference type component is inclined or a reference position of the upper surface is deviated.

### Patent Literature

Patent Literature 1: JP-T-2015-517222

### Summary of the Invention

### Technical Problem

However, in the component mounting method described above, since it is necessary to apply the adhesive separately from the application of the solder paste, there is a possibility that an additional adhesive application step is performed to reduce an efficiency of mounting work. In addition, since it is necessary to manage the adhesive separately from the solder paste, a management burden is also increased in a case where an operator or the like is not accustomed to handling of the adhesive.

A main object of the present disclosure is to provide appropriately mounting an upper surface reference type component without using an adhesive.

### Solution to Problem

The present disclosure employs the following means in order to achieve the main object described above.

A component mounting method of the present disclosure includes an application step of applying a specific solder paste including Sn and a metal other than Sn to a board; a disposition step of positioning and disposing an upper surface reference type component having a positioning reference on an upper surface with respect to one or more reference points on the board; and a reflow step of reflow-soldering the component by heating the board, in which in the specific solder paste, at least a part of the Sn is melted, and molten Sn and the metal other than Sn form an intermetallic compound in the reflow step, thereby fixing the upper surface reference type component to the board.

In the component mounting method of the present disclosure, in the specific solder paste, at least a part of the Sn is melted, and the molten Sn and the metal other than Sn form the intermetallic compound in the reflow step, thereby fixing the upper surface reference type component to the board. Since the self-alignment effect of the solder paste is suppressed by forming the intermetallic compound by the specific solder paste, it is possible to prevent the position of the upper surface reference type component positioned and disposed on the board from being deviated or the upper surface from being inclined in the reflow step. Therefore, it is possible to appropriately mount the upper surface reference type component without using an adhesive.

### Brief Description of Drawings

Fig. 1 is a configuration view schematically illustrating a configuration of component mounting system 1.
Fig. 2 is a configuration view schematically illustrating a configuration of printing device 10.
Fig. 3 is a configuration view schematically illustrating a configuration of mounting device 20.
Fig. 4 is a block diagram illustrating an electrical connection relationship among printing device 10, mounting device 20, reflow device 40, reflow inspection device 45, and management device 50.
Fig. 5 is a top view illustrating an example of upper surface reference type component 60.
Fig. 6 is a step diagram illustrating an example of component mounting process.
Fig. 7 is a flowchart illustrating an example of a dispenser application step.
Fig. 8 is a flowchart illustrating an example of a component disposition step.
Fig. 9 is an explanatory view of each process of a dispenser application step and a component disposition step.
Fig. 10 is an explanatory diagram illustrating an example of a type of solder.
Fig. 11 is an explanatory view illustrating a state where upper surface reference type component 60 is disposed and reflowed.
Fig. 12 is an explanatory view illustrating a state where upper surface reference type component 60 is disposed and reflowed.
Fig. 13 is a flowchart illustrating an example of a fillet shape inspection step.
Fig. 14 is an explanatory view illustrating an example of a fillet shape.
Fig. 15 is an explanatory view illustrating an example of each parameter of an inspection reference of a fillet shape.

### Description of Embodiments

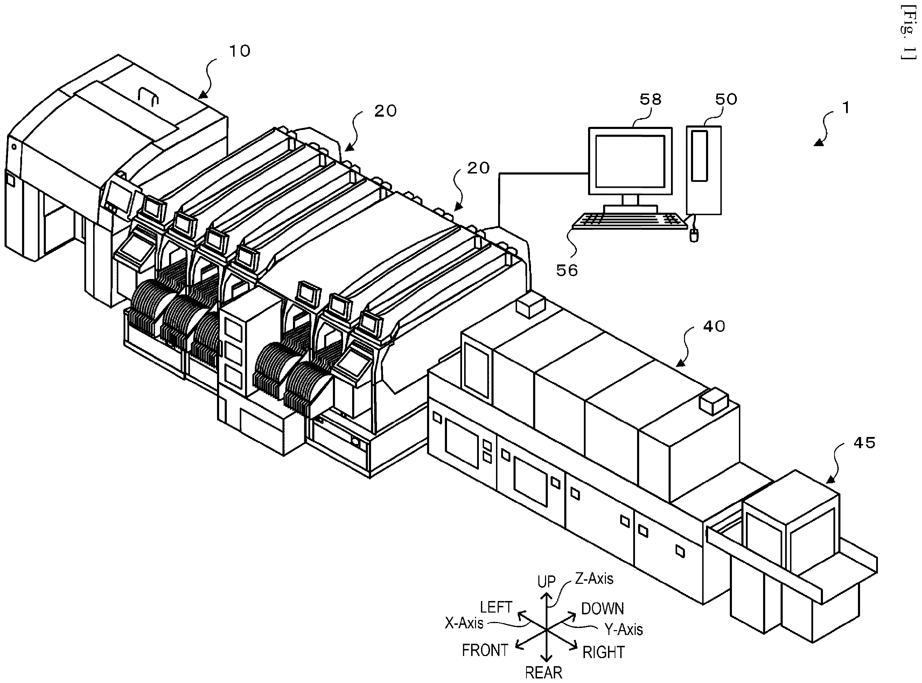

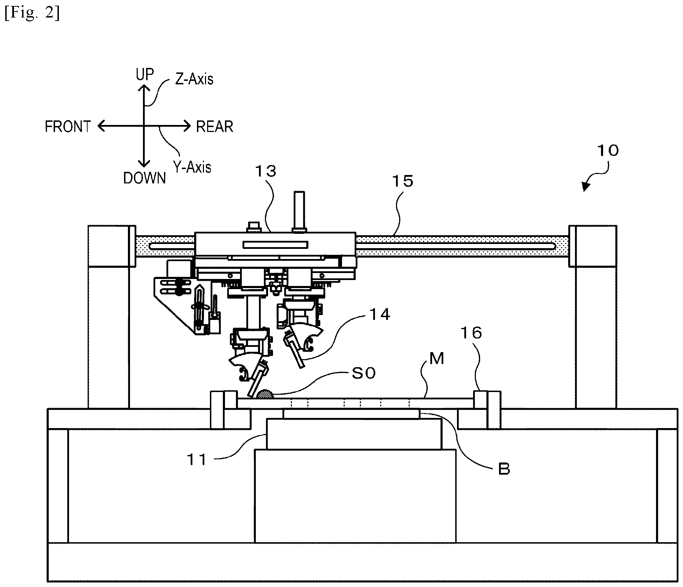

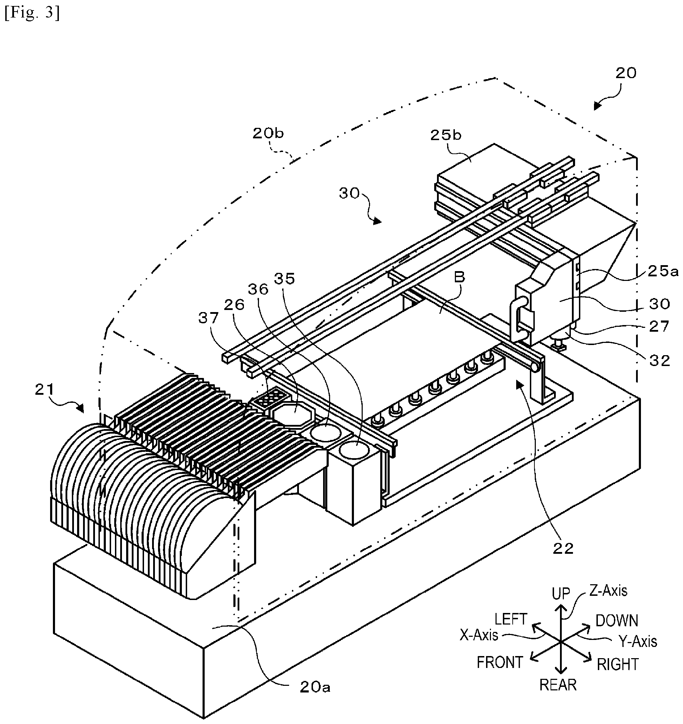

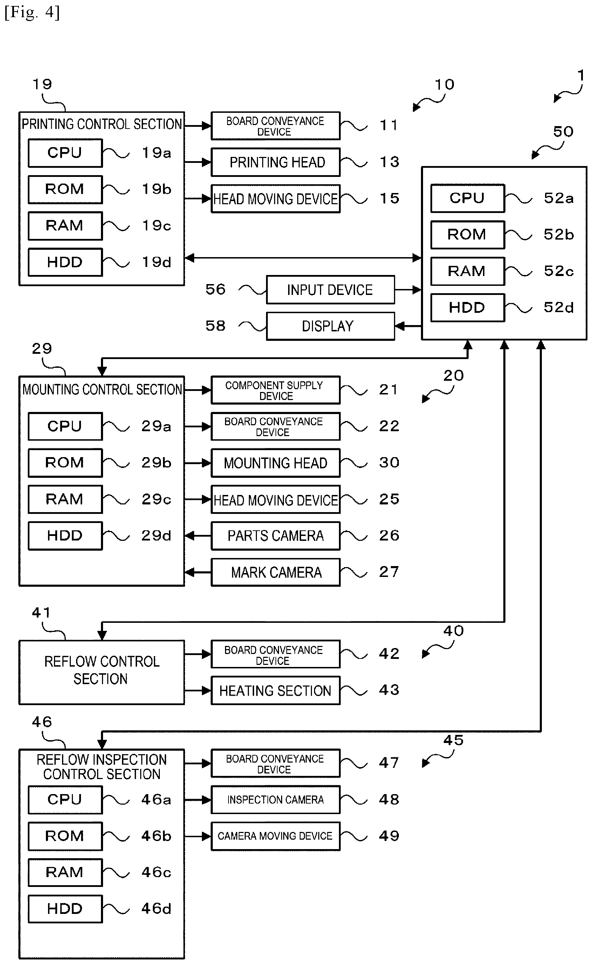

Next, an embodiment of the present disclosure will be described with reference to the drawings. Fig. 1 is a configuration view schematically illustrating a configuration of component mounting system 1. Fig. 2 is a configuration view schematically illustrating a configuration of printing device 10. Fig. 3 is a configuration view schematically illustrating a configuration of mounting device 20. Fig. 4 is a block diagram illustrating an electrical connection relationship among printing device 10, mounting device 20, reflow device 40, reflow inspection device 45, and management device 50. The left-right direction in Figs. 1 to 3 is X-direction, the front-rear direction is Y-direction, and an up-down direction is Z-direction.

As illustrated in Fig. 1, component mounting system 1 includes printing device 10, mounting device 20, reflow device 40, reflow inspection device 45, management device 50 for managing the entire system, and the like.

As illustrated in Figs. 2 and 4, printing device 10 includes board conveyance device 11 for conveying and fixing board B, printing head 13, head moving device 15 for moving printing head 13 in Y-direction, fixing frame 16 to which screen mask M is fixed, and printing control section 19 for controlling the entire device. Screen mask M is formed with a pattern hole (opening section) corresponding to a wiring pattern of board B, and is fixed to fixing frame 16 with a predetermined tension. Squeegee 14 of a flat plate-like member extending in X-direction is attached to printing head 13 liftably and lowerably in Z-direction. Printing device 10 performs screen printing in which a solder paste is applied to below board B via the pattern hole to form a wiring pattern (solder surface) by pushing the solder paste into the pattern hole of screen mask M by using squeegee 14. In the present embodiment, as will be described later, in the screen printing of printing device 10, normal solder paste S0 is applied.

As illustrated in Fig. 4, printing control section 19 is configured as a microprocessor centered on CPU 19a, and includes ROM 19b, RAM 19c, an HDD 19d, and the like in addition to CPU 19a. Printing control section 19 receives, for example, position signals from a position sensor (not illustrated) that detects a movement position of printing head 13, a position sensor (not illustrated) that detects an up-down position of squeegee 14, and the like. In addition, printing control section 19 outputs various control signals to board conveyance device 11, printing head 13, head moving device 15, and the like.

As illustrated in Figs. 3 to 4, mounting device 20 includes base 20a, housing 20b, component supply device 21, board conveyance device 22, head moving device 25, mounting head 30, mounting control section 29, and the like. Component supply device 21 is, for example, a tape feeder that supplies a component by feeding a tape in which the components are accommodated at predetermined pitches. A film is adhered to an upper surface of the tape and is peeled off before a supply position, and the tape is fed to the supply position in a state where the components is exposed. Board conveyance device 22 has a pair of conveyor belts that are provided with intervals between front and rear in Fig. 3 and spanned in the left-right direction, and conveys board B from the left to the right in the drawing by the conveyor belt. Head moving device 25 includes X-axis slider 25a to which mounting head 30 is attached, and Y-axis slider 25b to which X-axis slider 25a is movably attached in X-direction and which is configured to be movable in Y-direction, and moves mounting head 30 in XY-directions. In addition to these, mounting device 20 also includes parts camera 26, mark camera 27, and the like. Parts camera 26 is provided on base 20a, and captures an image of a component picked up by mounting head 30 from below. In addition, mark camera 27 is provided in mounting head 30, captures an image of a component supplied by component supply device 21 from above, and captures an image of a positioning reference mark (reference point) attached to board B from above.

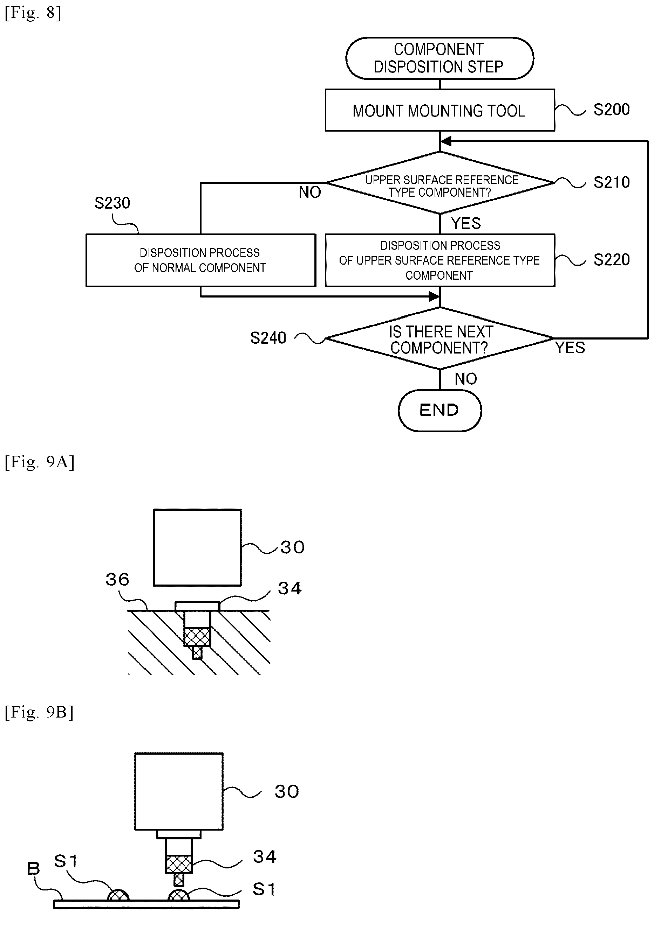

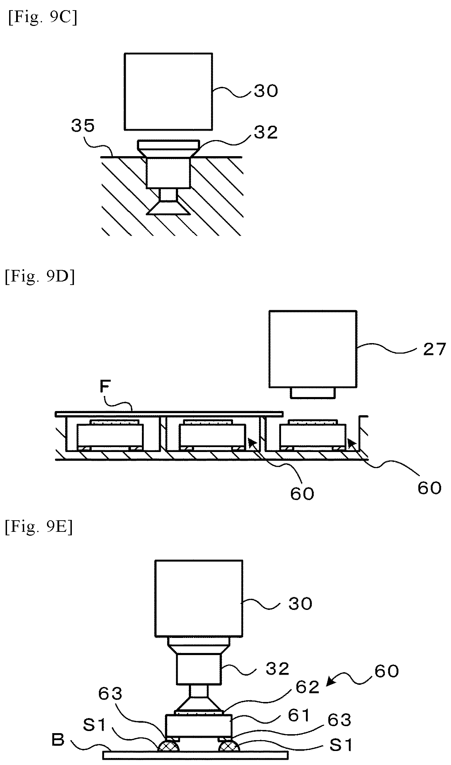

Mounting head 30 is configured to be detachable by multiple types of tools including mounting tool 32 and glue tool 34 (see Fig. 9), and different functions are assigned by the mounted tools. For example, when mounting tool 32 is mounted, mounting head 30 can perform a disposition operation (mounting operation) in which the upper surface of the component supplied by component supply device 21 which is picked up by a suction nozzle provided in mounting tool 32 and is disposed on board B. In addition, when glue tool 34 is mounted, mounting head 30 can perform an applying operation for applying the solder paste on board B by a dispenser provided in glue tool 34. In the present embodiment, as will be described later, specific solder paste S1 of a type different from normal solder paste S0 is applied by the dispenser of glue tool 34.

Mounting device 20 also includes mounting tool station 35, glue tool station 36, nozzle station 37, and the like on base 20a. Mounting tool station 35 is configured as an accommodation section for accommodating mounting tool 32. Glue tool station 36 is configured as an accommodation section for accommodating glue tool 34. Nozzle station 37 is configured as an accommodation section for accommodating multiple suction nozzles.

As illustrated in Fig. 4, mounting control section 29 is configured as a microprocessor centered on CPU 29a, and includes ROM 29b, RAM 29c, HDD 29d, and the like in addition to CPU 29a. Mounting control section 29 receives, for example, a position signal from a position sensor (not illustrated) that detects a movement position of mounting head 30, and image signals from parts camera 26 and mark camera 27. In addition, mounting control section 29 outputs various control signals to component supply device 21, board conveyance device 22, head moving device 25, parts camera 26, mark camera 27, mounting head 30, and the like.

As illustrated in Fig. 4, reflow device 40 includes board conveyance device 42 for conveying board B on which components are disposed, heating section 43 for heating board B conveyed by board conveyance device 42, and reflow control section 41 for controlling the entire device. Reflow device 40 heats board B to a predetermined reflow temperature (for example, 220°C or 260°C) by heating section 43, thereby melting the solder on board B. The molten solder is solidified by cooling, and thereby the component is electrically connected and fixed on board B.

As illustrated in Fig. 4, reflow inspection device 45 includes board conveyance device 47 that conveys and fixes board B in X-direction, inspection camera 48 mounted on board B to capture the image of the component after reflow, camera moving device 49 that moves inspection camera 48 in Y-direction, and reflow inspection control section 46 that controls the entire device. Reflow inspection control section 46 is configured as a microprocessor centered on CPU 46a, and includes ROM 46b, RAM 46c, HDD 46d, and the like in addition to CPU 46a. Reflow inspection control section 46 receives, for example, a position signal from a position sensor (not illustrated) that detects the movement position of inspection camera 48, an image signal from inspection camera 48, and the like. In addition, reflow inspection control section 46 outputs various control signals to board conveyance device 47, inspection camera 48, camera moving device 49, and the like. Reflow inspection control section 46 inspects a state of the component on board B after the reflow process based on the image captured by inspection camera 48. HDD 46d stores various inspection conditions such as reference parameters necessary for the inspection. Reflow inspection control section 46 measures a positional deviation and a rotational angle deviation of the component, a fillet shape of the solder, and the like from the image captured by inspection camera 48, and determines good or bad quality thereof based on whether they are within a reference range by comparing with the reference parameter.

As illustrated in Fig. 4, management device 50 is, for example, a general-purpose computer, and includes CPU 52a, ROM 52b, RAM 52c, HDD 52d, and the like. An input signal from input device 56 is inputted to management device 50. Management device 50 outputs a display signal to display 58. HDD 52d stores job information including a production program of board B and other production information. Here, the production program means a program for determining which components are to be mounted on which board B in which order in mounting device 20, and how many boards B so mounted are to be manufactured. In addition, the production information includes component information (type of the component and supply position of the component) related to a component of a mounting target, tool information related to the tool to be used, a type of the solder to be used, a target applying position (XY-coordinates), a target disposition position (XY-coordinates) of the component, and the like. Management device 50 is communicably connected to printing control section 19 of printing device 10, mounting control section 29 of mounting device 20, and reflow control section 41 of reflow device 40, and exchanges various information and control signals.

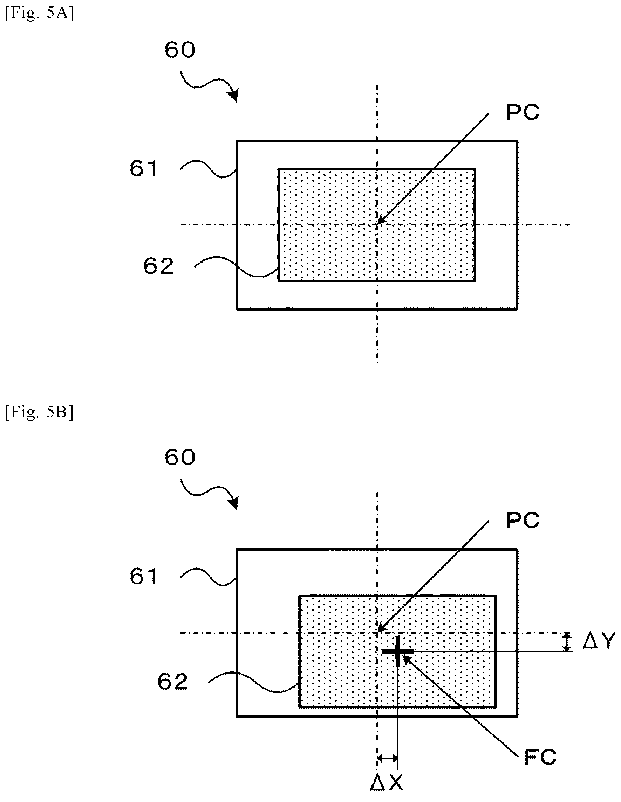

Here, Fig. 5 is a top view illustrating an example of upper surface reference type component 60. Upper surface reference type component 60 is a surface mount device-light emitting diode (SMD-LED) in which light emitting section (positioning target) 62 is provided on an upper surface of component main body 61, and electrode 63 (see Fig. 9) is provided on a lower surface of component main body 61. In a case where such upper surface reference type component 60 is mounted on board B, mounting device 20 is required to position and dispose upper surface reference type component 60 with respect to a positioning reference mark attached to board B with reference to positioning target center FC which is the light emitting center of light emitting section 62. As illustrated in the drawing, in the manufacturing process of upper surface reference type component 60, there are variations in the position of light emitting section 62 with respect to a component outer shape. For example, in Fig. 5A, the light emitting center (positioning target center FC) of light emitting section 62 is not deviated with respect to its ideal position (for example, component center PC), but in Fig. 5B, the light emitting center of light emitting section 62 is illustrated to be deviated by ΔX in X-direction and ΔY in Y-direction with respect to its ideal position. In this case, in the mounting step, upper surface reference type component 60 is disposed on board B with the positional correction so that positioning target center FC as a reference coincides with the target disposition position on board B.

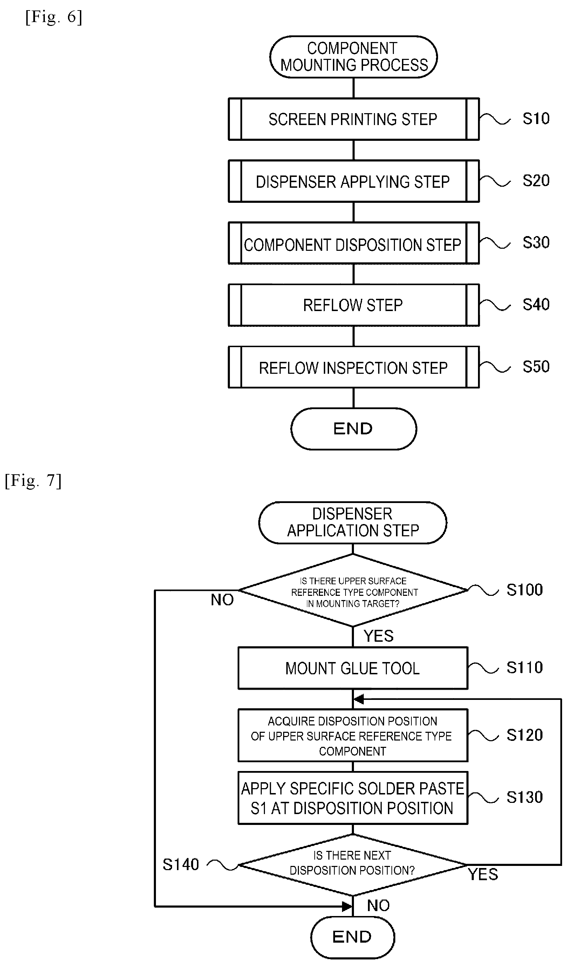

An operation of component mounting system 1 of the present embodiment configured as described above, particularly, each step for mounting each component including upper surface reference type component 60 on board B will be described below. Fig. 6 is a step diagram illustrating an example of the component mounting process. Each step of the component mounting process is performed by printing device 10, mounting device 20, and reflow device 40, respectively, in accordance with a command from CPU 52a of management device 50. The component mounting process includes a screen printing step (S10), a dispenser application step (S20), a component disposition step (S30), a reflow step (S40), and a reflow inspection step (S50). In the screen printing step, CPU 52a causes printing device 10 to execute screen printing for applying normal solder paste S0 to board B. In the dispenser application step, in a case where upper surface reference type component 60 is present in the component of the mounting target on board B, CPU 52a causes mounting device 20 to perform the dispenser application to apply specific solder paste S1 by glue tool 34 at the disposition position of upper surface reference type component 60. In the component disposition step, CPU 52a causes mounting device 20 to dispose upper surface reference type component 60 or normal components (non-upper surface reference type component and lower surface reference component) other than upper surface reference type component 60 on board B. The normal component is a component that does not require to be disposed with reference to the upper surface because the positioning target such as light emitting section 62 is not provided on the upper surface, and is disposed with reference to a center position or the like of the lower surface by capturing an image of the lower surface. In the present embodiment, it is assumed that upper surface reference type component 60 and the normal component are disposed in a mixed manner on one board B. In the reflow step, the CPU 52 causes reflow device 40 to execute the reflow process of board B on which the component is disposed. In the reflow inspection step, the CPU 52 causes reflow inspection device 45 to execute an appearance inspection of board B on which the reflow process has been performed. Hereinafter, details of the dispenser application step, the component disposition step, and the reflow inspection step will be described in order.

Fig. 7 is a flowchart illustrating an example of the dispenser application step, Fig. 8 is a flowchart illustrating an example of the component disposition step, and Fig. 9 is an explanatory view of each process of the dispenser application step and the component disposition step. In the dispenser application step of Fig. 7, CPU 29a of mounting control section 29 first determines whether there is upper surface reference type component 60 in the component of the mounting target mounted on board B (S100), and when it is determined that there is no upper surface reference type component 60, completes the dispenser application step as it is. On the other hand, when determining that there is upper surface reference type component 60, CPU 29a controls head moving device 25 to move mounting head 30 to an area above glue tool station 36, and glue tool 34 is mounted on mounting head 30 (S110 and Fig. 9A). In a case where mounting tool 32 is mounted on mounting head 30, CPU 29a first moves mounting head 30 to above mounting tool station 35, stores mounting tool 32 in mounting tool station 35, and then performs the process of S110. Next, CPU 29a acquires the target disposition position of upper surface reference type component 60 included in the job information received from management device 50 (S120). Subsequently, CPU 29a controls head moving device 25 to move mounting head 30 (glue tool 34) above the target disposition position of upper surface reference type component 60, and controls mounting head 30 to apply specific solder paste S1 to board B (S130 and Fig. 9B). Then, CPU 29a determines whether there is a next target disposition position of upper surface reference type component 60 (S140), and when it is determined that there is the next target disposition position, the process returns to S120. On the other hand, when determining that there is no next target disposition position, CPU 29a completes the dispenser application step.

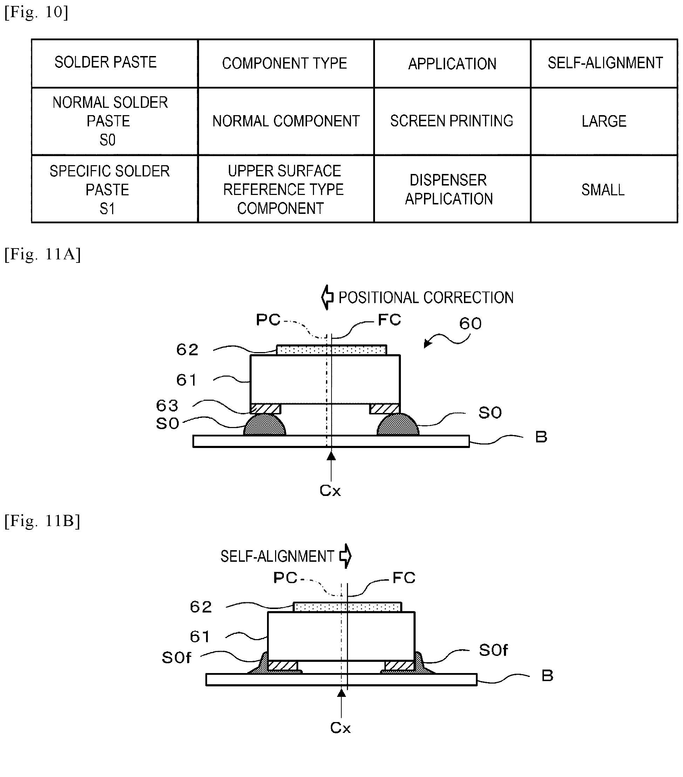

Here, Fig. 10 is an explanatory view of the type of solder. In the present embodiment, two types of solder pastes, that is, normal solder paste S0 and specific solder paste S1 are used. Normal solder paste S0 is applied by screen printing of printing device 10, and is used at a mounting location of a normal component other than upper surface reference type component 60. Specific solder paste S1 is dispenser-applied by glue tool 34 in mounting device 20 and is used at the mounting location of upper surface reference type component 60. Each of solder pastes S0 and S1 is a paste-like material in which solder powder and flux are mixed. As normal solder paste S0, for example, Sn-Ag based solder, Sn-Ag-Cu based solder, or the like which is generally used as a lead-free solder, is used. In the present embodiment, as normal solder paste S0, Sn-3.0Ag-0.5Cu (SAC305), in which Ag is 3.0% by mass, Cu is 0.5% by mass, and the remainder is Sn, is used. On the other hand, as specific solder paste S1, for example, Sn-Cu based solder, Sn-Au based solder, or the like is used. For example, in a case where an Sn-Cu based solder is used, in specific solder paste S1, Sn is preferably 35% by mass or more and 85% by mass or less, and more preferably 50% by mass or more and 65% by mass or less. In addition, Cu is preferably 15% by mass or more and 65% by mass or less, and more preferably 35% by mass or more and 50% by mass or less. With such a ratio, when the solder paste is heated in the reflow step, an intermetallic compound (IMC) described later can be sufficiently formed around Cu. When Cu is less than 15% by mass, sufficient formation of the intermetallic compound cannot be expected, or when Cu is more than 65% by mass, the material cost increases more than necessary, so that such a ratio is preferable.

In the component disposition step of Fig. 8, CPU 29a of mounting control section 29 first controls head moving device 25 to move mounting head 30 to an area above mounting tool station 35, and mounting tool 32 on mounting head 30 (S200 and 9C). In a case where glue tool 34 is mounted on mounting head 30, CPU 29a first moves mounting head 30 to an area above glue tool station 36, stores glue tool 34 in glue tool station 36, and then performs the processing of S200.

Next, CPU 29a determines whether the next target component is upper surface reference type component 60 based on the mounting order of the components included in the job information received from management device 50 (S210), and when it is determined that the next target component is upper surface reference type component 60, performs positioning target center FC with respect to the positioning reference mark attached to board B to perform the disposition process of upper surface reference type component 60 (S220). In S220, CPU 29a captures an image of the upper surface of upper surface reference type component 60 exposed by the peeling of the film F attached to the upper surface of the tape by mark camera 27 in component supply device 21 (Fig. 9D). Then, CPU 29a processes the captured upper surface image, recognizes the component outer shape and the position of positioning target center FC of the upper surface, and corrects the target disposition position of upper surface reference type component 60 so that the positional deviation in X-direction and Y-direction between the position of positioning target center FC and the ideal position (component center PC) with respect to the component outer shape (see Fig. 5B) is eliminated. In addition, CPU 29a picks up upper surface reference type component 60 to the suction nozzle of mounting tool 32, moves mounting head 30 (mounting tool 32) on parts camera 26, and captures an image of the lower surface of upper surface reference type component 60 picked up by the suction nozzle with parts camera 26. Then, CPU 29a processes the captured lower surface image, recognizes the component outer shape, corrects the target disposition position of upper surface reference type component 60 so that the positional deviation in X-direction and Y-direction between the component outer shape and the pickup center (center of the suction nozzle) is eliminated, and disposes upper surface reference type component 60 on board B (Fig. 9E).

On the other hand, when it is determined in S210 that the next target component is not upper surface reference type component 60, CPU 29a performs the disposition process of the normal component (S230). In S230, CPU 29a picks up the normal component to the suction nozzle of mounting tool 32, moves mounting head 30 (mounting tool 32) onto parts camera 26, and images the lower surface of the normal component picked up by the suction nozzle with parts camera 26. Then, CPU 29a processes the captured lower surface image, recognizes the component outer shape, corrects the target disposition position of the normal component so as to eliminate the positional deviation in X-direction and Y-direction between the component outer shape and the pickup center (center of the suction nozzle), and disposes the normal component on board B. When the component is disposed on board B in this manner, CPU 29a determines whether there is the next component of the mounting target based on the mounting order (S240), and when it is determined that there is the next component, the process returns to S210, and when it is determined that there is no next component, the component disposition step is completed.

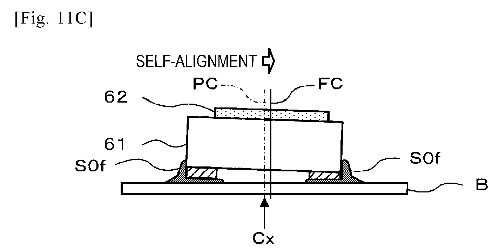

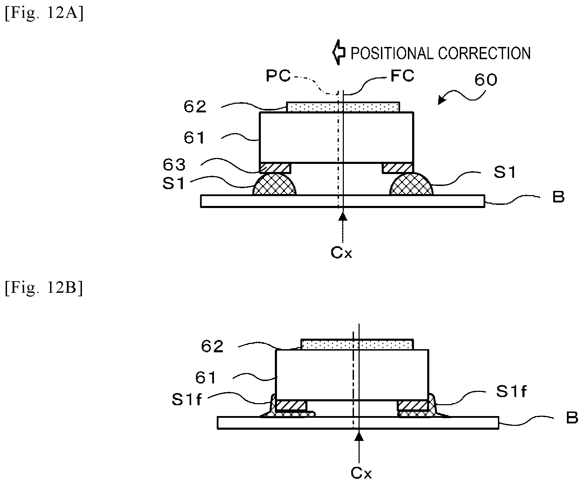

Board B on which the disposition of the components is completed in this manner is sent to reflow device 40, and thereby the reflow process is performed. Figs. 11 and 12 are explanatory views illustrating a state where upper surface reference type component 60 is disposed and reflowed. Fig. 11 illustrates a case of a comparative example in which upper surface reference type component 60 is solder-bonded using normal solder paste S0, and Fig. 12 illustrates a case of the present embodiment in which upper surface reference type component 60 is solder-bonded using specific solder paste S1. In addition, Figs. 11A and 12A illustrate a state after component disposition, and Figs. 11B, 11C, and 12B illustrate a state after the reflow process. Fillet shape S0f represents a shape of a bonding portion of normal solder paste S0 after the reflow process, and fillet shape S1f represents a shape of a bonding portion of specific solder paste S1 after the reflow process. In each of Fig. 11A and Fig. 12A, the position of positioning target center FC of light emitting section 62 on the upper surface is deviated with respect to component center PC of component main body 61 (component outer shape). In addition, it illustrates a state where positioning target center FC is disposed so as to match target disposition position Cx by correcting the deviation. Therefore, component center PC deviates to the left side in the drawing, so that positioning target center FC coincides with target disposition position Cx.

Here, as described above, specific solder paste S1 generally has a Cu content higher than that of normal solder paste S0. Since a melting point (about 1085°C) of Cu is higher than a melting point (about 232°C) of Sn and a reflow temperature (260°C or the like), Cu is difficult to melt and Sn is easily melted in the reflow step. The molten Sn reacts with the surface of Cu to form an intermetallic compound (IMC) such as a CuSn alloy around Cu. In specific solder paste S1, since the content of Cu is usually larger than that of normal solder paste S0 and the formation of the intermetallic compound is promoted, a bonding layer, in which the intermetallic compound is bonded in a network shape, is relatively firmly formed. On the other hand, in normal solder paste S0, since the content of Cu and Ag other than Sn is small in comparison with specific solder paste S1, and it is difficult to form a strong bonding layer of the intermetallic compound, a change in the paste shape is increased in comparison with specific solder paste S1 during the reflow step. Therefore, a self-alignment effect of centering fine positional deviation of the component during melting by the surface tension of the solder melted during the reflow step is large in normal solder paste S0, and is small (almost none) in specific solder paste S1. This self-alignment effect acts on the component outer shape.

In the comparative example illustrated in Fig. 11, since normal solder paste S0 is used, the outer shape of upper surface reference type component 60 is centered with respect to the application position of the solder paste by the self-alignment effect during the reflow step. Therefore, even if upper surface reference type component 60 is disposed by correcting the deviation of positioning target center FC of the upper surface in the component disposition step, the component outer shape is centered so as to eliminate the correction, and positioning target center FC may be solder-bonded in a positional deviated state (Fig. 11B). In addition, since normal solder paste S0 has a large change in the paste shape, a difference in a supporting force occurs between the left and right solder pastes in Fig. 11 due to heating unevenness or the like, so that upper surface reference type component 60 may be solder-bonded in an inclined state (Fig. 11C). In these cases, the position of light emitting section 62 on the upper surface of component main body 61 deviates from the target disposition position, or an optical axis of light emitting section 62 is inclined. In addition, although not illustrated, a variation in an upper surface height of light emitting section 62 of upper surface reference type component 60 may also be increased. Therefore, in a case where a lens is disposed so as to cover upper surface reference type component 60, an irradiation situation through the lens also changes due to the variation in the upper surface height of light emitting section 62. Therefore, it is difficult for light emitting section 62 to accurately irradiate light in designed direction, position, and range. In recent years, since relatively high accuracy is required for irradiating light from the LED, such positional deviation of light emitting section 62, inclination of the optical axis, variation in the upper surface height, and the like pose problems.

On the other hand, in the present embodiment illustrated in Fig. 11, since specific solder paste S1 having a small self-alignment effect is used, the component is hardly moved by the self-alignment effect during the reflow process. Therefore, upper surface reference type component 60 is solder-bonded while maintaining the disposition position corrected in the component disposition step (Fig. 12B). In addition, since the bonding layer of the intermetallic compound is formed relatively firmly, specific solder paste S1 can hold upper surface reference type component 60 while suppressing an increase in the difference in supporting force between the left and right solder pastes in Fig. 12 although being melted. Therefore, it is possible to prevent upper surface reference type component 60 from becoming in an inclined state. Therefore, by using specific solder paste S1, it is possible to prevent the position (positioning target center FC) of light emitting section 62 from deviating from the target disposition position or the optical axis of light emitting section 62 from inclining due to the self-alignment effect of the melted solder. In addition, since specific solder paste S1 has a relatively high force for maintaining the paste shape, the upper surface height of light emitting section 62 after the reflow process may be at a position higher than that of normal solder paste S0. However, since the upper surface height is also relatively stable, parameters such as the application amount of solder may be adjusted or the height of the above-described lens may be adjusted in advance by experiments, simulations, or the like so as to obtain a target upper surface height.

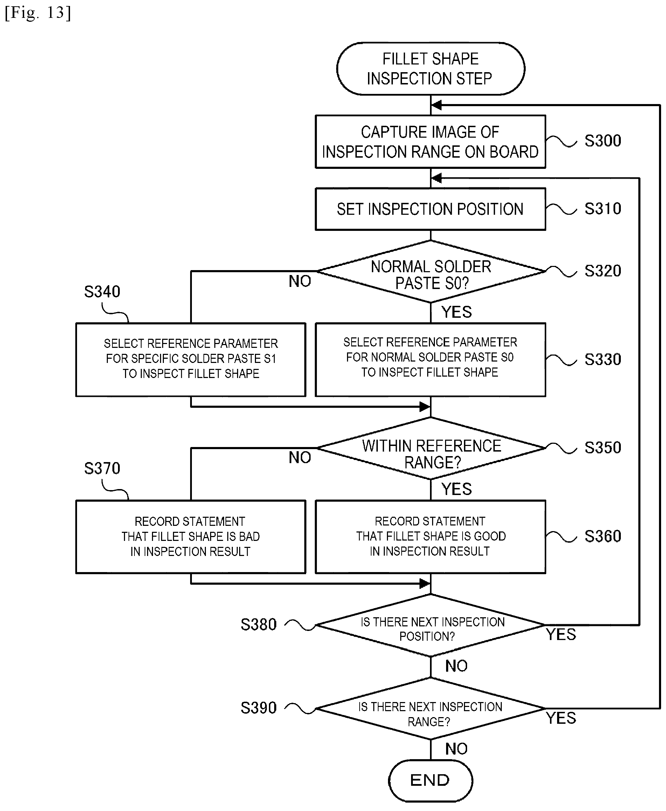

The following is a description of the reflow inspection step. Here, an inspection step of a fillet shape serving as a solder bonding portion will be described. Fig. 13 is a flowchart illustrating an example of the fillet shape inspection step. In the fillet shape inspection step, CPU 46a of reflow inspection control section 46 first controls board conveyance device 47, inspection camera 48, and camera moving device 49 so as to capture an image of a predetermined inspection range on board B (S300), and sets an inspection position from the captured image (S310). Next, CPU 46a determines whether the solder paste applied to the set inspection position is normal solder paste S0 (S320), and when it is determined that the solder paste is normal solder paste S0, sets the reference parameter for normal solder paste S0 to inspect fillet shape S0f (S330). On the other hand, when determining that the solder paste is not normal solder paste S0 but specific solder paste S1 in S220, CPU 46a sets the reference parameter for specific solder paste S1 to inspect fillet shape S1f (S340).

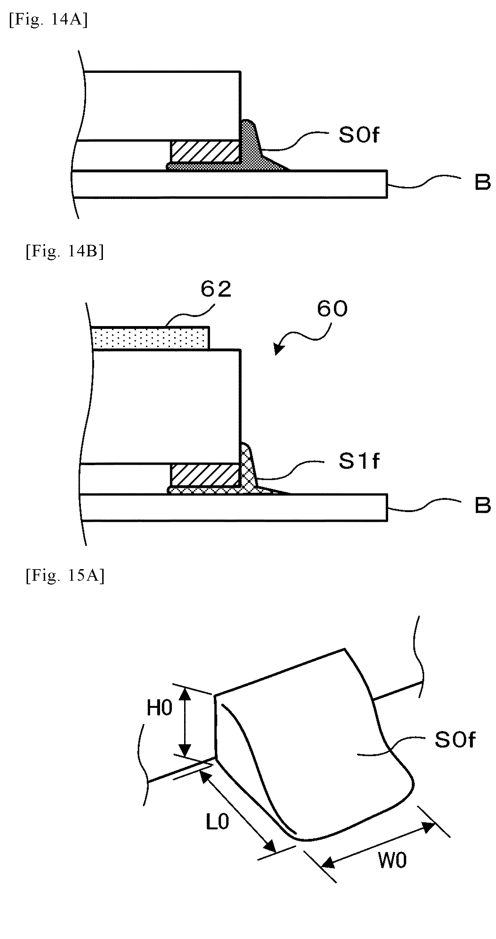

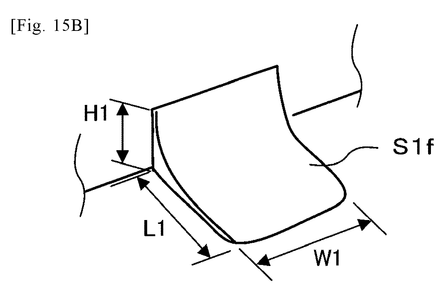

Here, Fig. 14 is an explanatory view illustrating an example of the fillet shape, and Fig. 15 is an explanatory view illustrating an example of each parameter of the inspection reference of the fillet shape. In Figs. 14A and 15A, fillet shape S0f of normal solder paste S0 for bonding the normal component having no light emitting section 62 to the upper surface of the component is illustrated. In addition, Figs. 14B and 15B illustrate fillet shape S1f of specific solder paste S1 for bonding upper surface reference type component 60. As illustrated in the drawings, fillet shape S1f of specific solder paste S1 tends to have a shape in which a bulge thereof is smaller than that of fillet shape S0f of normal solder paste S0 and is collapsed. This is considered that because the strength of the bonding layer of the intermetallic compound differs, there is a difference in wettability and the like when being melted. The inspection parameter is determined in advance in accordance with such a difference in the tendency and stored in HDD 46d. For example, width W0, height H0, and length L0 are determined as the reference parameters of fillet shape S0f, and width W1, height HI, and length L1 are determined as the reference parameters of fillet shape S1f. As the reference parameters, all of the width, the height, and the length need not be determined according to the type of the solder paste, and at least any one of them may be determined. In particular, since the height is easily changed, it is preferable that heights H0 and H1 are determined as the reference parameters.

When the inspection of the fillet shape is performed in this manner, CPU 46a determines whether the inspected fillet shape is within the reference range of the reference parameter (S350). When determining that the fillet shape is within the reference range, CPU 46a stores a statement that the fillet shape is good in HDD 46d in association with the inspection position (S360), and when determining that the fillet shape is outside the reference range, CPU 46a stores a statement that the fillet shape is bad in HDD 46d in association with the inspection position (S370). Then, CPU 46a determines whether there is the next inspection position within the captured inspection range (S380), and when it is determined that there is the next inspection position, returns the process to S310. On the other hand, when determining that there is no next inspection position, CPU 46a determines whether there is the next inspection range on the board (S390), when determining that there is the next inspection range, returns the process to S300, and when determining that there is no next inspection range, completes the inspection process routine.

Here, a correspondence relationship between constituent elements of the present embodiment and constituent elements of the present disclosure will be clarified. The dispenser application step of S20 (Fig. 7) of the component mounting process of the present embodiment corresponds to the application step, the component disposition step of S30 (Fig. 8) of the component mounting process corresponds to the disposition step, and the reflow step of S40 of the component mounting process corresponds to the reflow step. The reflow inspection step (fillet shape inspection step in Fig. 13) of S50 of the component mounting process corresponds to the inspection step. Component mounting system 1 corresponds to the component mounting system. Printing device 10 and mounting device 20 (in a case where glue tool 34 is mounted on mounting head 30) correspond to the application section, mounting device 20 (in a case where mounting tool 32 is mounted on mounting head 30) corresponds to the disposition section, reflow device 40 corresponds to the reflow section, and reflow inspection device 45 corresponds to the inspection section.

In the component mounting process of the present embodiment described above, the self-alignment effect of the solder paste can be suppressed by disposing upper surface reference type component 60 on board B using specific solder paste S1, and forming the intermetallic compound in specific solder paste S1 in the reflow step. Therefore, since it is possible to prevent the position of upper surface reference type component 60 positioned and disposed on board B from being deviated or the upper surface from being inclined in the reflow step, it is possible to appropriately mount upper surface reference type component 60 without using an adhesive.

In addition, in specific solder paste S1, Cu having a melting point higher than that of Sn and higher than the heating temperature in the reflow step does not melt in the reflow step and maintains its shape, and thereby molten Sn forms a bonding layer of a strong intermetallic compound around Cu to suppress the self-alignment effect.

In addition, specific solder paste S1 is used for upper surface reference type component 60, and normal solder paste S0 having a large self-alignment effect is used for the normal component. As for the normal component to be disposed with reference to only the outer shape, it is possible to correct a fine positional deviation and mount the component at an appropriate position by the self-alignment effect of normal solder paste S0. On the other hand, with respect to upper surface reference type component 60 for which the position (positioning target center FC) of light emitting section 62 on the upper surface is important, it is possible to appropriately prevent the position thereof being deviated or the upper surface from being inclined by performing the centering of the outer shape due to the self-alignment effect. In addition, because of being used in a relatively wide range, normal solder paste S0 is applied by screen printing, and an appropriate amount of specific solder paste S1 can be applied to the disposition position of upper surface reference type component 60 by dispenser application without waste. Since specific solder paste S1 having a large content of Cu or the like is relatively expensive, it is possible to suppress an unnecessary cost by applying specific solder paste S1 without waste.

In the reflow inspection step, since the fillet shape is inspected by selectively using the reference parameter for normal solder paste S0 and the reference parameter for specific solder paste S1, the appearance inspection of the fillet shape can be appropriately performed.

In addition, since specific solder paste S1 has a Sn content of 50% by mass or more and 65% by mass or less and a Cu content of 35% by mass or more and 50% by mass or less, the bonding layer of the intermetallic compound can be sufficiently formed in the reflow step to secure high strength.

In addition, upper surface reference type component 60 is an SMD-LED, and by using specific solder paste S1, it is possible to appropriately prevent the position of light emitting section 62 from differing from the target disposition position or the optical axis of light emitting section 62 from inclining, and thereby light irradiation can be performed with high accuracy.

The present disclosure is not limited to the embodiments described above, and it is needless to say that various forms can be implemented within the technical scope of the present disclosure.

For example, in the embodiments described above, the Sn-Cu based solder is exemplified as specific solder paste S1, and Cu is preferably 15% by mass or more and 65% by mass or less, more preferably 35% by mass or more and 50% by mass or less; however, the configuration is not limited to this. For example, in specific solder paste S1, it is sufficient if the content of Cu, Au, or the like is larger than that of normal solder paste S0 so that the intermetallic compound is easily formed in comparison with normal solder paste S0. In addition, specific solder paste S1 may further include, for example, another metal such as Ni.

In the embodiments described above, the metal other than Sn of specific solder paste S1 is a metal having a melting point higher than that of Sn and higher than the heating temperature of the reflow step, but is not limited to this, and may be a metal having a melting point higher than that of at least Sn.

In the embodiments described above, normal solder paste S0 and specific solder paste S1 are selectively used according to the mounting target component; however, the configuration is not limited to this. For example, in a case where upper surface reference type component 60 is included in the mounting target component of board B, all the components of board B may be mounted by using specific solder paste S1.

In the embodiments described above, the application of normal solder paste S0 is performed by screen printing, and the application of specific solder paste S1 is performed by the dispenser application; however, the configuration is not limited to this. Depending on the size of the application range, the number of upper surface reference type components 60 to be disposed, or the like, the application of normal solder paste S0 may be performed by the dispenser application, and the application of specific solder paste S1 may be performed by the screen printing. In addition, the dispenser application is performed by mounting device 20, that is, not only printing device 10 but also mounting device 20 where glue tool 34 is mounted on mounting head 30 corresponds to the application section, but is not limited to this, and the application of the solder paste may be performed by printing device 10 and not be performed by mounting device 20. In this case, printing device 10 may correspond to the application section, mounting device 20 may correspond to the disposition section, and mounting device 20 may have a configuration in which glue tool 34 is not mounted on mounting head 30. In addition, any of normal solder paste S0 and specific solder paste S1 may be performed by pin transfer. Alternatively, normal solder paste S0 and specific solder paste S1 are not limited to those applied by different methods, but may be applied by the same method.

In the embodiments described above, the SMD-LED is exemplified as upper surface reference type component 60, but is not limited to this, and any component having a positioning reference on the upper surface may be used.

In the embodiments described above, the fillet shape is inspected by selectively using the reference parameter for normal solder paste S0 and the reference parameter for specific solder paste S1 in the reflow inspection step; however, the configuration is not limited to this. In the inspection of other shapes, dimensions, positions, and the like in the reflow inspection step, the reference parameters of the inspection may be selectively set according to the type of the solder paste. In addition, in addition to the inspection step, in the application step, the parameter related to the application may be selectively set according to the type of the solder paste, in the component disposition step, the parameter related to the disposition of the component may be selectively set according to the type of the solder paste, or in the reflow step, the parameter related to the heating of board B may be selectively set according to the type of the solder paste. That is, various parameters related to the mounting of the component may be selectively settable according to the type of the solder paste.

For example, in the component disposition step, as parameters related to the disposition of components, a force for pressing the component on board B when disposing the component, a position in the height direction where the component is disposed (position at which the nozzle releases the pick-up), or the like may be settable according to the type of the solder paste. As described above, when specific solder paste S1 is used, the upper surface height of the component after the reflow process may be higher than that of normal solder paste S0. Therefore, by enabling the parameter related to the disposition of the components to be set according to the type of the solder paste, the component can be mounted more appropriately. In the reflow step, as parameters related to the heating of board B, for example, a heating temperature, a heating time, or the like may be settable according to the type of the solder paste. In a case where normal solder paste S0 and specific solder paste S1 are mixed in one board B, the parameter for specific solder paste S1 may be used as the parameter related to the heating of board B. In addition, which parameter to use may be determined in consideration of the size of the application range between normal solder paste S0 and specific solder paste S1, the disposition number of the upper surface reference type components 60, and the like. Alternatively, in the reflow step, the heating parameter in a case where only normal solder paste S0 is used, the heating parameter in a case where only specific solder paste S1 is used, and the heating parameter in a case where normal solder paste S0 and specific solder paste S1 are mixed and used may be selectively used.

Here, the component mounting method of the present disclosure may be configured as follows. For example, in the component mounting method of the present disclosure, in the specific solder paste, the metal other than Sn may be a metal having a melting point higher than that of the Sn and higher than a heating temperature of the reflow step. Accordingly, even if the Sn melts in the reflow step, the metal other than Sn does not melt and maintains the shape, so that the molten Sn forms the intermetallic compound around the metal. Therefore, the self-alignment effect of the solder paste can be further suppressed.

In the component mounting method of the present disclosure, the specific solder paste may be used for mounting the upper surface reference type component, and another solder paste having a self-alignment effect in the reflow step larger than that of the specific solder paste may be used for mounting other components that do not have the positioning reference on the upper surface. Accordingly, it is possible to prevent the position of the upper surface reference type component from being deviated or the upper surface from being inclined while correcting a fine positional deviation by the self-alignment effect and mounting the other components at appropriate positions.

In the component mounting method of the present disclosure, in the application step, the specific solder paste and the other solder paste may be applied by any of screen printing, pin transfer, and dispenser application, respectively. Accordingly, the application can be performed by an appropriate method according to the usage amount, the usage range, and the like of each solder paste.

The component mounting method of the present disclosure may further include an inspection step of inspecting an appearance of the board, in which at least one parameter of a parameter related to the disposition of the component in the disposition step, a parameter related to the heating of the board in the reflow step, and a parameter related to an inspection reference in the inspection step may be selectively settable, and the parameter may be selected based on whether a type of the solder paste used to mount the component is the specific solder paste or the other solder paste. Accordingly, the disposition of components, the heating of the board, and the appearance inspection of the board can be appropriately performed according to the type of the solder paste.

In the component mounting method of the present disclosure, the specific solder paste may have a content of the Sn of 50% by mass or more and 65% by mass or less, and a content of the metal other than Sn of 35% by mass or more and 50% by mass or less. Accordingly, since in the reflow step, the metal that maintains the shape without melting is sufficiently contained, it is possible to secure high strength by the intermetallic compound.

In the component mounting method according to the present disclosure, the upper surface reference type component may be an SMD-LED. Since such an SMD-LED is required to accurately irradiate light while preventing the inclination of the component, it is highly meaningful to apply the present disclosure.

Another component mounting method of the present disclosure is a component mounting method for mounting a component on a board by using at least one of a specific solder paste including Sn and a metal other than Sn, and another solder paste different from the specific solder paste, in which a parameter related to the mounting of the component is selectively settable, and the parameter is selected based on whether a type of the solder paste used to mount the component is the specific solder paste or the other solder paste. Accordingly, it is possible to appropriately mount the component according to the type of the solder paste.

A component mounting system of the present disclosure, which applies a specific solder paste including Sn and a metal other than Sn to a board, positions and disposes an upper surface reference type component having a positioning reference on an upper surface with respect to one or more reference points on the board, and reflow-solders the component by heating the board, in which in the specific solder paste, at least a part of the Sn is melted, and molten Sn and the metal other than Sn form an intermetallic compound during the reflow-soldering, thereby fixing the upper surface reference type component to the board. Therefore, similarly to the component mounting method described above, it is possible to appropriately mount the upper surface reference type component without using an adhesive.

A component mounting system of the present disclosure includes an application section configured to apply a solder paste to a board; a disposition section configured to position and dispose a component including an SMD-LED with respect to one or more reference points on the board; a reflow section configured to heat the board to reflow-solder the component; and an inspection section configured to perform an appearance inspection of the board, in which in mounting of the SMD-LED, a specific solder paste is used, and in mounting of a component other than the SMD-LED, another solder paste having a self-alignment effect in the reflow of the reflow section larger than that of the specific solder paste is used, at least one parameter of a parameter related to the disposition of the component in the disposition section, a parameter related to the application of the solder paste in the application section, a parameter related to the heating of the board in the reflow section, and a parameter related to an inspection reference in the inspection section is selectively settable, and the parameter is selected based on whether a type of the solder paste used to mount the component is the specific solder paste or the other solder paste. Therefore, similarly to the component mounting method described above, it is possible to appropriately mount the upper surface reference type component without using an adhesive. In addition, the application (printing) of the solder paste, the disposition of the components, the heating of the board, and the appearance inspection of the board can be appropriately performed according to the type of the solder paste.

### Industrial Applicability

The present disclosure can be used in the manufacturing industry of the component mounting systems or the like.

### Reference Signs List

1 component mounting system, 10 printing device, 11, 22, 42, 47 board conveyance device, 13 printing head, 14 squeegee, 15 head moving device, 16 fixing frame, 19 printing control section, 19a, 29a, 46a, 52a CPU, 19b, 29b, 46b, 52b ROM, 19c, 29c, 46c, 52c RAM, 19d, 29d, 46d, 52d HDD, 20 mounting device, 20a base, 20b housing, 21 component supply device, 25 head moving device, 25a X-axis slider, 25b Y-axis slider, 26 parts camera, 27 mark camera, 29 mounting control section, 30 mounting head, 32 mounting tool, 34 glue tool, 35 mounting tool station, 36 glue tool station, 37 nozzle station, 40 reflow device, 41 reflow control section, 43 heating section, 45 reflow inspection device, 46 reflow inspection control section, 48 inspection camera, 49 camera moving device, 50 management device, 56 input device, 58 display, 60 upper surface reference type component, 61 component main body, 62 light emitting section, B board, FC positioning target center, M screen mask, PC component center, S solder, S0 normal solder paste, S1 specific solder paste

## Claims

1. A component mounting method comprising:
an application step of applying a specific solder paste including Sn and a metal other than Sn to a board;
a disposition step of positioning and disposing an upper surface reference type component having a positioning reference on an upper surface with respect to one or more reference points on the board; and
a reflow step of reflow-soldering the component by heating the board,
wherein in the specific solder paste, at least a part of the Sn is melted, and molten Sn and the metal other than Sn form an intermetallic compound in the reflow step, thereby fixing the upper surface reference type component to the board.

2. The component mounting method according to 1. ,
wherein in the specific solder paste, the metal other than Sn is a metal having a melting point higher than that of the Sn and higher than a heating temperature of the reflow step.

3. The component mounting method according to 1. or 2,
wherein the specific solder paste is used for mounting of the upper surface reference type component, and
another solder paste having a self-alignment effect in the reflow step larger than that of the specific solder paste is used for mounting of other components that do not have the positioning reference of the upper surface.

4. The component mounting method according to 3. ,
wherein in the application step, the specific solder paste and the other solder paste are applied by any of screen printing, pin transfer, and dispenser application, respectively.

5. The component mounting method according to 3. or 4, further comprising:
an inspection step of inspecting an appearance of the board,
wherein at least one parameter of a parameter related to the disposition of the component in the disposition step, a parameter related to the heating of the board in the reflow step, and a parameter related to an inspection reference in the inspection step is selectively settable, and
the parameter is selected based on whether a type of the solder paste used to mount the component is the specific solder paste or the other solder paste.

6. The component mounting method according to any one of Claims 1 to 5,
wherein the specific solder paste has a content of the Sn of 50% by mass or more and 65% by mass or less, and a content of the metal other than Sn of 35% by mass or more and 50% by mass or less.

7. The component mounting method according to any one of Claims 1 to 6,
wherein the upper surface reference type component is an SMD-LED.

8. A component mounting method for mounting a component on a board by using at least one of a specific solder paste including Sn and a metal other than Sn, and another solder paste different from the specific solder paste,
wherein a parameter related to the mounting of the component is selectively settable, and
the parameter is selected based on whether a type of the solder paste used to mount the component is the specific solder paste or the other solder paste.

9. A component mounting system that applies a specific solder paste including Sn and a metal other than Sn to a board, positions and disposes an upper surface reference type component having a positioning reference on an upper surface with respect to one or more reference points on the board, and reflow-solders the component by heating the board,
wherein in the specific solder paste, at least a part of the Sn is melted, and molten Sn and the metal other than Sn form an intermetallic compound during the reflow-soldering, thereby fixing the upper surface reference type component to the board.

10. A component mounting system comprising:
an application section configured to apply a solder paste to a board;
a disposition section configured to position and dispose a component including an SMD-LED with respect to one or more reference points on the board;
a reflow section configured to heat the board to reflow-solder the component; and
an inspection section configured to perform an appearance inspection of the board,
wherein in mounting of the SMD-LED, a specific solder paste is used, and in mounting of a component other than the SMD-LED, another solder paste having a self-alignment effect in the reflow of the reflow section larger than that of the specific solder paste is used,
at least one parameter of a parameter related to the disposition of the component in the disposition section, a parameter related to the application of the solder paste in the application section, a parameter related to the heating of the board in the reflow section, and a parameter related to an inspection reference in the inspection section is selectively settable, and
the parameter is selected based on whether a type of the solder paste used to mount the component is the specific solder paste or the other solder paste.
